# EUROPÄISCHE PATENTSCHRIFT

(11) **EP 1 311 341 B1**
(45) Veröffentlichungstag und Bekanntmachung des Hinweises auf die Patenterteilung: **16.06.2004**
(21) Anmeldenummer: 01980263.6
(22) Anmeldetag: 23.08.2001
(51) Int. Cl.: B01F 13/00, B01F 5/02, B01F 5/06

(54) **VERFAHREN UND STATISCHER MIKROVERMISCHER ZUM MISCHEN MINDESTENS ZWEIER FLUIDE**
METHOD AND STATISTICAL MICROMIXER FOR MIXING AT LEAST TWO LIQUIDS
PROCEDE ET MICROMELANGEUR STATIQUE DESTINES AU MELANGE D'AU MOINS DEUX FLUIDES

(30) Priorität: 25.08.2000 DE 10041823
(43) Veröffentlichungstag der Anmeldung: 21.05.2003
(73) Patentinhaber: INSTITUT FÜR MIKROTECHNIK MAINZ GmbH, 55129 Mainz-Hechtsheim (DE); MGT Mikroglas Technik AG, 55129 Mainz (DE)
(72) Erfinder: LÖWE, Holger, 55276 Oppenheim (DE); SCHIEWE, Jörg, 55129 Mainz-Hechtsheim (DE); HESSEL, Volker, 65510 Hünstetten-Wallbach (DE); DIETRICH, Thomas, 60594 Frankfurt am Main (DE); FREITAG, Andreas, 60495 Frankfurt am Main (DE)
(74) Vertreter: Fuchs Mehler Weiss & Fritzsche
(86) Internationale Anmeldenummer: PCT/EP2001/009728
(87) Internationale Veröffentlichungsnummer: WO 2002/016017

(56) Entgegenhaltungen:
- EP-A- 0 903 174
- EP-A- 0 928 785
- DE-A- 19 541 266
- DE-A- 19 816 886
- EHRFELD W, HESSEL V, LÖWE H: "Microreactors" 2000 , WILEY-VCH , GERMANY XP002190806 243750 in der Anmeldung erwähnt Seite 44, Absatz 4 -Seite 46, Absatz 7 Seite 80, Absatz 4 -Seite 82, Absatz 6; Abbildungen 3.3,3.37,3.38

## Beschreibung

Die Erfindung betrifft ein Verfahren und einen statischen Mikrovermischer zum Mischen mindestens zweier Fluide.

Ziel beim Mischen mindestens zweier Fluide ist das Erreichen einer gleichförmigen Verteilung der beiden Fluide in einer bestimmten, in der Regel möglichst kurzen Zeit. Hierzu werden Mischvorgänge mit einem hohen spezifischen Energieeintrag angestrebt. Von Vorteil sind Mischvorgänge mit gerichteten Strömungen, die die stattfindenden Mischprozesse unter Zuhilfenahme von Modellbetrachtungen vorhersagbar machen. Besonders vorteilhaft werden hierzu statische Mikrovermischer eingesetzt, wie sie in der Übersicht von W. Ehrfeld, V. Hessel, H. Löwe in Microreactors, New Technology for Modern Chemistry, Wiley-VCH 2000, Seiten 41 bis 85 dargestellt sind. Mit bekannten statischen Mikrovermischern werden durch Erzeugen abwechselnd benachbarter Fluidlamellen einer Stärke im µm-Bereich Mischzeiten zwischen 1 s und wenigen Millisekunden erzielt. Im Gegensatz zu dynamischen Mischern, in denen turbulente Strömungsverhältnisse vorherrschen, wird durch die vorgegebene Geometrie ein exaktes Einstellen der Breite der Fluidlamellen und damit der Diffusionswege ermöglicht. Die hierdurch erzielte sehr enge Verteilung der Mischzeiten erlaubt vielfältige Möglichkeiten der Optimierung von chemischen Umsetzungen im Hinblick auf Selektivität und Ausbeute. Ein weiterer Vorteil von statischen Mikrovermischern ist die Miniaturisierung und damit Integrierbarkeit in weitere Systeme, wie Wärmetauscher und Reaktoren. Die Anwendungspotenziale umfassen Flüssig-Flüssig und Gas-Gas Mischungen, einschließlich Reaktionen in den entsprechenden Regimen, sowie Flüssig-Flüssig Emulsionen, Gas-Flüssig Dispersionen, Fest-Flüssig-Dispersionen und damit auch Mehrphasen- und Phasentransfer-Reaktionen, Extraktionen und Absorption.

Ein nach dem Prinzip der Multilamination arbeitender statischer Mikrovermischer weist in einer Ebene eine mikrostrukturierte Interdigitalstruktur aus ineinandergreifenden Kanälen einer Breite von 25 µm oder 40 µm auf (a. a. O. Seite 64 bis 73). Die beiden zu mischenden Fluide werden durch die Kanäle in eine Vielzahl voneinander getrennter Fluidströme aufgeteilt, die entgegengesetzt parallel zueinander strömend und alternierend zueinander angeordnet sind. Durch einen Schlitz werden die benachbarten Fluidströme senkrecht aus der Ebene nach oben abgeführt und miteinander kontaktiert. Mittels für die Massenfertigung geeigneter Strukturierungsverfahren lassen sich die Kanalgeometrien und damit die Fluidlamellenbreite nur begrenzt bis in den unteren µm-Bereich reduzieren.

Eine weitere Reduzierung der nach dem Multilaminationsprinzip erhaltenen Fluidlamellen kann durch sogenanntes hydrodynamisches Fokussieren erzielt werden. Solch ein statischer Mikrovermischer zum Umsetzen gefährlicher Stoffe wird von T. M. Floyd et al. auf den Seiten 171 bis 179 in Microreaction technology: industrial prospects; proceedings of the Third International Conference on Microreaction Technology/ IMRET3, editor: W. Ehrfeld, Springer 2000 vorgestellt. Abwechselnd benachbarte Kanäle für die beiden zu mischenden Fluide münden in einem Halbkreis radial von außen in eine trichterförmig ausgezogene und in einen engen, langen Kanal übergehende Kammer. Der in der Kammer vereinigte Fluidlamellenstrom wird hierbei in den engen Kanal überführt, wodurch eine Verkleinerung der Fluidlamellenbreite stattfindet. Auch bei reduzierten Lamellenbreiten im unteren µm-Bereich werden durch Diffusion bedingte Mischzeiten im Millisekundenbereich erhalten, was für einige Anwendungen, insbesondere ultra-schnelle Reaktionen, noch zu lang ist. Zudem weist dieser Mikrovermischer bedingt durch den langen, als Reaktionsraum dienenden Kanal eine große Bauform auf.

Die Erfindung hat zur Aufgabe ein Verfahren und einen statischen Mikrovermischer zum Mischen mindestens zweier Fluide zur Verfügung zu stellen, die ein schnelles Mischen der Fluide bei hoher Mischgüte und kleinem Bauraum ermöglichen.

Die Aufgabe wird erfindungsgemäß mit einem Verfahren gemäß Anspruch 1 und einem statischen Mikrovermischer gemäß Anspruch 10 gelöst.

Nachfolgend wird unter dem Begriff Fluid ein gasförmiger oder flüssiger Stoff oder ein Gemisch solcher Stoffe verstanden, das einen oder mehrere feste, flüssige oder gasförmige Stoffe gelöst oder dispergiert enthalten kann.

Der Begriff Mischen umfasst auch die Vorgänge Lösen (Blenden), Dispergieren, Emulgieren und Suspendieren. Demzufolge umfasst der Begriff Mischung Lösungen, Flüssig-Flüssig-Emulsionen, Gas-Flüssig und Fest-Flüssig-Dispersionen.

Unter einer Vielzahl von Fluidströmen oder Fluidkanälen werden je Fluid zwei oder mehr, vorzugsweise drei oder mehr, besonders bevorzugt fünf oder mehr, Fluidströme bzw. Fluidkanäle verstanden. Abwechselnd benachbarte Fluidlamellen oder Fluidkanäle bedeutet bei zwei Fluiden A, B, dass diese in mindestens einer Ebene alternierend, eine Reihenfolge von ABAB ergebend, nebeneinander liegen. Der Begriff "abwechselnd benachbart" umfasst bei drei Fluiden A, B, C unterschiedliche Reihenfolgen, wie beispielsweise ABCABC oder ABACABAC. Die Fluidlamellen oder Fluidkanäle können auch in mehr als einer Ebene abwechselnd benachbart liegen, beispielsweise in zwei Dimensionen schachbrettartig zueinander versetzt liegen. Die den unterschiedlichen Fluiden zugehörigen Fluidströme und Fluidkanäle sind vorzugsweise gleichgerichtet oder entgegengerichtet parallel zueinander angeordnet.

Das erfindungsgemäße Verfahren zum Mischen von mindestens zwei Fluiden umfasst mindestens vier Verfahrensschritte. Im 1. Schritt wird eine Vielzahl getrennter Fluidströme der beiden Fluide jeweils einer Breite im Bereich von 1 µm bis 1 mm und einer Tiefe im Bereich von 10 µm bis 10 mm zusammengeführt, wobei sich abwechselnd benachbarte Fluidlamellen der beiden Fluiden bilden. Im 2. Schritt werden die so vereinigten Fluidströme unter Ausbildung eines fokussierten Gesamtfluidstroms abgeführt. Im 3. Schritt wird der so erhaltene Gesamtfluidstrom als Fluidstrahl in eine Expansionskammer mit einer zum fokussierten Gesamtfluidstrom größeren Querschnittsfläche senkrecht zur Strömungsrichtung des fokussierten Gesamtfluidstroms eingeleitet. Im letzten Verfahrensschritt wird die so gebildete Mischung abgeleitet.

Das Zusammenführen erfolgt derart, dass die zunächst getrennten Fluidströme in einen Raum einströmen. Hierbei können die Fluidströme parallel zueinander oder ineinanderführend, beispielsweise radial nach innen, ausgerichtet sein. Beim Zusammenführen bilden sich Fluidlamellen aus, deren Querschnittsflächen zunächst denen der Fluidströme entsprechen. Durch das Abführen als fokussierter Gesamtfluidstrom findet eine Reduzierung der Breite und / oder der Querschnittsfläche der Fluidlamellen statt, bei gleichzeitiger Erhöhung der Fließgeschwindigkeit. Der so beschleunigte fokussierte Gesamtfluidstrom wird als Fluidstrahl (Jet) in die Expansionskammer eingeleitet. Durch das Aufweiten der Fluidlamellen in der Expansionskammer treten senkrecht zur Hauptströmung gerichtete Kräfte (Scherkräfte) auf, die im Vergleich mit alleiniger diffusiver Mischung kürzere Mischzeiten erzielen lassen. Insbesondere der Prozess der Fragmentierung in einzelne Teilchen als diskontinuierliche Phase in einer kontinuierlichen Phase und damit die Bildung von Emulsionen und Dispersionen wird vorteilhaft beeinflusst. Von besonderem Vorteil ist hierbei die Wirkung des Fluidstrahls als Saug- und Schleppstrahl sowie das Auftreten gerichteter Wirbel.

Bevorzugt werden die vereinigten Fluidströme derart fokussiert, dass das Verhältnis der Querschnittsfläche des fokussierten Gesamtfluidstroms zu der Summe der Querschnittsflächen der zusammenzuführenden Fluidströme jeweils senkrecht zur Strömungsrichtung im Bereich von 1 zu 1,5 bis 1 zu 500, vorzugsweise im Bereich von 1 zu 2 bis 1 zu 50, liegt. Je kleiner das Verhältnis ist, desto stärker wird die Lamellenbreite reduziert und desto stärker wird die Fließgeschwindigkeit erhöht, mit der der fokussierte Gesamtfluidstrom als Fluidstrahl in die Expansionskammer eingeleitet wird. Vorteilhaft weist der fokussierte Gesamtfluidstrom einen über seine Länge gleichbleibenden Querschnitt auf. Denkbar ist auch eine in Richtung der Expansionskammer abnehmende Querschnittsfläche, wobei obiges Verhältnis für den Bereich mit kleinster Querschnittsfläche gilt.

Bevorzugt liegt das Verhältnis der Länge des fokussierten Gesamtfluidstroms zu seiner Breite im Bereich von 1 zu 1 bis 30 zu 1, vorzugsweise im Bereich 1,5 zu 1 bis 10 zu 1. Hierbei soll der fokussierte Gesamtfluidstrom möglichst ausreichend lang sein, um eine ausreichend fokussierende Wirkung unter Beibehaltung der laminaren Strömungsverhältnisse zu erzwingen. Jedoch sollte der fokussierte Gesamtfluidstrom kurz ausgebildet werden, um im Hinblick auf eine kurze Mischzeit den Gesamtfluidstrom möglichst rasch als Fluidstrahl in die Expansionskammer einleiten zu können.

Vorteilhaft wird der fokussierte Gesamtfluidstrom derart als Fluidstrahl in den Expansionskammer eingeleitet, dass sich zumindestens in einer Ebene, vorzugsweise zu beiden Seiten des Fluidstrahls Wirbel, insbesondere stationäre Wirbel, bilden. Solche stationären Wirbel bilden sich besonders in den Bereichen aus, entlang derer der Fluidstrahl vorbeiströmt und diese Bereiche zur Rotation bringt. Bevorzugt wird der Fluidstrahl symmetrisch in den Raum eingeleitet, so dass sich zumindestens in einer Ebene zu beiden Seiten stationäre Wirbel ausbilden. Ist die Expansionskammer im Vergleich zum fokussierten Gesamtfluidstrom nicht nur in der Breite, sondern über den gesamten Querschnitt aufgeweitet, so ist es von besonderem Vorteil, wenn sich allseitig um den Fluidstrahl stationäre Wirbel bilden. Durch die in den stationären Wirbeln auftretenden Scherkräfte bei zumindest teilweise turbulenten Strömungsbedingungen wird der Mischvorgang positiv beeinflusst. Von Vorteil ist die Expansionskammer hierbei so ausgebildet, dass die Wirbel nicht in sogenannten Totwasserbereichen, sondern in durchflossenen Bereichen gebildet werden.

Gemäß einer Ausführungsform wird zumindest ein Teil des Fluidstroms nach dem Einleiten in die Expansionskammer erneut unter Fokussierung abgeleitet. Dies kann den gesamten aus der Expansionskammer austretenden Fluidstrahl umfassen oder nur einen Teil hiervon, wobei der andere Teil vorteilhaft als fertige Mischung abgeleitet wird. Ein Vorteil durch das erneute Fokussieren ist, dass eine weitere Kontaktierung von Bereichen stattfindet, die noch nicht vollständig gemischt sind. Vorteilhaft wird hierbei der fokussierte Fluidstrom als Fluidstrahl erneut unter Wirbelbildung in eine weitere Expansionskammer eingeleitet.

Gemäß einer weiteren Ausführungsform werden die folgenden beiden Verfahrensschritte ein oder mehrfach wiederholt. Im ersten dieser beiden Verfahrensschritte wird zumindest ein Teil des Fluidstroms nach dem vorhergehenden Einleiten in die Expansionskammer unter Ausbildung eines fokussierten Fluidstroms abgeführt. Im zweiten Schritt wird der fokussierte Fluidstrom in eine weitere Expansionskammer eingeleitet, die eine zum fokussierten Fluidstrom größere Querschnittsfläche senkrecht zur Strömungsrichtung des fokussierten Fluidstroms aufweist. Nach dem ein oder mehrfachen Durchführen dieser beiden Schritte wird die gebildete Mischung abgeleitet. Durch das wiederholte Durchführen von Fokussieren und Einleiten in eine Expansionskammer wird ein besonders intensives Mischen erzielt, was insbesondere bei der Bildung von Emulsionen und Dispersionen mit kleinen Teilchengrößen von Vorteil ist. Bezüglich der vorteilhaften Durchführung des Fokussierens und des Einleitens wird auf die angeführten bevorzugten Varianten hingewiesen.

Vorteilhaft wird in die Expansionskammer ein weiteres Fluid eingeleitet. Das Einleiten kann an einer oder mehreren Stellen, die vorzugsweise symmetrisch zu dem Fluidstrahl liegen, durchgeführt werden. Das weitere Fluid kann einen die Mischung stabilisierenden Hilfsstoff, beispielsweise einen Emulgator, aufweisen.

Vorteilhaft wird zumindest ein Teil der gebildeten Mischung aus dem oder den Bereichen der Expansionskammer mit Wirbelbildung abgeleitet. Hierbei kann die gebildete Mischung in einen oder mehreren Strömen, die vorzugsweise symmetrisch zum Fluidstrahl liegen, abgeleitet werden. Hierbei erfolgt besonders vorteilhaft das Ableiten aus den Bereichen der stationären Wirbel, in denen eine Mischung hoher Mischgüte vorliegt.

Entsprechend einer bevorzugten Ausführungsform wird der fokussierte Gesamtfluidstrom auf eine sich in der Expansionskammer befindliche Struktur, die den Fluidstrahl ablenkt, geleitet. Diese Prallstruktur kann eine ebene oder gebogene Fläche oder eine Struktur zum Ablenken und/ oder Aufspalten des Fluidstrahls sein. Ebenso kann die der Einmündung des Fokussierungskanals gegenüberliegende Wand der Expansionskammer so ausgebildet sein, dass diese als Prallstruktur dient. Bei dieser Ausführungsform werden extrem hohe spezifische Energiedichten unter Verwendung eines vorlaminierten und fokussierten Gesamtfluidstroms und damit ein hoher Grad an Turbulenz erzielt.

Die hohe Turbulenz führt zur Bildung kleiner Wirbel die aufgrund der auftretenden hohen Scherkräfte zu sehr kleinen Teilchendurchmessern, beispielsweise Tröpfchendurchmesser bei Emulsionen, führt. Im Gegensatz zu bekannten Verfahren ist eine Bildung von Voremulsionen nicht erforderlich.

Gemäß einer weiteren Ausführungsform werden die ersten beiden Verfahrensschritte jeweils gleichzeitig und räumlich voneinander getrennt zweioder mehrfach durchgeführt. Hierdurch werden entsprechend zwei oder mehr fokussierte Gesamtfluidströme erhalten, die in eine gemeinsame Expansionskammer eingeleitet werden. Besonders vorteilhaft werden hierbei die fokussierten Gesamtfluidströme als Fluidstrahl derart in die gemeinsame Expansionskammer eingeleitet, dass diese aufeinander treffen, d. h. miteinander kollidieren. Die einzuleitenden Gesamtfluidströme können die gleichen Fluide oder auch unterschiedliche Fluide aufweisen, die dann erst in dem gemeinsamen Raum kontaktiert und gemischt werden. Hier können sich, wie zuvor beschrieben, weitere Schritte wie erneutes Fokussieren und Einleiten als Fluidstrahl in eine Expansionskammer anschließen. Wie bei der vorherigen Ausführungsform unter Verwendung einer Prallstruktur werden extrem hohe spezifische Energiedichten unter Verwendung zweier oder mehrerer vorlaminierter und fokussierter Gesamtfluidströme und damit ein hoher Grad an Turbulenz erzielt, wodurch insbesondere bei Suspensionen, Dispersionen und Emulsionen sehr kleine Teilchendurchmesser erhalten werden.

Der erfindungsgemäße statische Mikrovermischer zum Mischen mindestens zweier Fluide weist eine Vielzahl abwechselnd benachbarter Fluidkanäle, eine Einlasskammer, einen Fokussierungskanal, eine Expansionskammer und einen Auslasskanal zum Ableiten der gebildeten Mischung auf. Die Vielzahl abwechselnd benachbarter Fluidkanäle weist eine Breite im Bereich von 1 µm bis 1 mm und eine Tiefe im Bereich von 10 µm bis 10 mm zur getrennten Zuführung der Fluide als Fluidströme auf. Die Einlasskammer, in die die Fluidkanäle einmünden, dient dem Zusammenführen der Vielzahl getrennter Fluidströme der beiden Fluide. Der Fokussierungskanal ist zum Abführen der in der Einlasskammer vereinigten Fluidströme unter Ausbildung eines fokussierten Gesamtfluidstroms fluidisch mit der Einlasskammer verbunden. Die Expansionskammer, in die der Fokussierungskanal einmündet und der fokussierte Gesamtfluidstrom als Fluidstrahl eintritt, weist eine zum Fokussierungskanal größere Querschnittsfläche senkrecht zur Achse des Fokussierungskanals auf. Der mindestens eine mit der Expansionskammer fluidisch in Verbindung stehende Auslasskanal dient zum Ableiten der gebildeten Mischung.

Vorzugsweise weist die Einlasskammer in Ihrem Innern zumindest in einer Ebene eine konkave oder halb konkave Form auf, wobei die konkave Fläche, in der der Fokussierungskanal mittig einmündet, der Fläche, in die die Fluidkanäle einmünden, gegenüber liegt. Durch die konkave Form wird ein rasches Zusammenführen und Abführen in den Fokussierungskanal unter Erhalt der Fluidlamellen erreicht. Es ist jedoch auch denkbar, die vereinigten Fluidströme allmählich auf den Fokussierungskanal zuzuführen, wozu die Einlasskammer in zumindest einer Ebene dreieckförmig-zulaufend oder trichterförmig ausgebildet ist.

Im Sinne einer einfachen technischen Realisierung ist es von Vorteil, wenn die Fluidkanäle, die Einlasskammer, der Fokussierungskanal und / oder die Expansionskammer die gleiche Tiefe aufweisen. Hierbei ist es ebenfalls von Vorteil, wenn die Einmündungen der Fluidkanäle zumindest im Bereich der Einlasskammer in einer Ebene liegen.

Bevorzugt ist der Fokussierungskanal derart ausgebildet, dass das Verhältnis der Querschnittsfläche des Fokussierungskanals zu der Summe der Querschnittsflächen der in die Einlasskammer einmündenden Fluidkanäle jeweils senkrecht zur Kanalachse im Bereich von 1 zu 1,5 bis 1 zu 500, vorzugsweise im Bereich von 1 zu 2 bis 1 zu 50, liegt. Hierdurch wird ein im Vergleich zur vorgegebenen Breite der Fluidkanäle weiteres Reduzieren der Lamellenbreite und / oder Querschnittsfläche und damit einhergend ein Erhöhen der Fließgeschwindigkeit erzielt. Vorteilhaft weist der Fokussierungskanal über seine gesamte Länge einen im wesentlichen gleichbleibenden Querschnitt auf. Denkbar ist auch, dass die Querschnittsfläche des Fokussierungskanals hin zur Expansionskammer abnimmt, wobei obiges Verhältnis der Querschnittsflächen für den Bereich mit kleinster Querschnittsfläche anzuwenden ist.

Bevorzugt liegt das Verhältnis der Länge des Fokussierungskanals zu seiner Breite im Bereich von 1 zu 1 bis 30 zu 1, vorzugsweise im Bereich von 1,5 zu 1 bis 10 zu 1. Hierbei wird die Länge des Fokussierungskanals vorteilhaft so gewählt, dass ein Fokussieren auf hohe Fließgeschwindigkeit unter Erhalt der Fluidlamellen sowie im Sinne eines schnellen Mischens ein rasches Einleiten in die Expansionskammer erfolgt.

Gemäß einer Ausführungsform ist die Expansionskammer ein von einem im Querschnitt zum Fokussierungskanal breiteren Kanal gebildet und schließt sich in Längserstreckung an diesen an.

Vorzugsweise liegt das Verhältnis der Querschnittsfläche der Expansionskammer in zumindest einem mittleren Bereich zu der Querschnittsfläche des in die Expansionskammer einmündenden Fokussierungskanals senkrecht zur Kanalachse im Bereich von 1,5 zu 1 bis 500 zu 1, vorzugsweise im Bereich von 2 zu 1 bis 50 zu 1. Durch das Aufweiten im Übergangsbereich zwischen dem Fokussierungskanal und der Expansionskammer wird der fokussierte Gesamtfluidstrom als Fluidstrahl in die Expansionskammer eingeleitet, wobei senkrecht zum Fluidstrahl gerichtete Kräfte auftreten, die ein rasches Mischen unterstützen. Insbesondere bei der Bildung von Emulsionen und Dispersionen unterstützen diese quergerichteten Kräfte den Vorgang der Fragmentierung der Fluidlamellen in einzelne Teilchen. Je nach Ausgestaltung der Expansionskammer bilden sich seitlich des einschießenden Fluidstrahls sich zeitlich verändernde oder stationäre Wirbel. Vorteilhaft besitzt die Expansionskammer im Innern in zumindest einer Ebene eine an die Ausbildung von stationären Wirbeln angepasste Form. Hierdurch werden Totwasserbereiche vermieden, so dass alle Bereiche der Expansionskammer ständig durchströmt werden.

Gemäß einer Ausführungsform geht die Expansionskammer in einen weiteren, als Auslasskanal dienenden Fokussierungskanal über. Dieser dient zum Ableiten und erneuten Fokussieren zumindest eines Teils des Gesamtfluidstroms. Vorteilhaft schließt sich der weitere Fokussierungskanal in Längserstreckung an den in die Expansionskammer einmündenden ersten Fokussierungskanal an, um zumindest einen Teil des in die Expansionskammer eintretenden Fluidstrahls zu erfassen.

Eine weitere Ausführungsform des statischen Mikrovermischers weist eine Folge von einem oder mehreren weiteren Fokussierungskanälen auf, in die jeweils die vorhergehende Expansionskammer übergehen, sowie einer oder mehreren Expansionskammern. Die weiteren Fokussierungskanäle dienen zum Ableiten und Fokussieren zumindest eines Teils des Gesamtfluidstroms und münden in die jeweils nachfolgende weitere Expansionskammer ein. Ein mit der in der Folge letzten Expansionskammer fluidisch in Verbindung stehender Auslasskanal dient zum Ableiten der gebildeten Mischung. Solche statischen Mikrovermischer mit in Folge angeordneten Fokussierungskanälen und Expansionskammern eignen sich besonders vorteilhaft zur Herstellung von Emulsionen und Dispersionen mit enger Teilchengrößenverteilung. Vorteilhaft ist die Querschnittsfläche des weiteren Fokussierungskanals kleiner gleich der Querschnittsfläche vorangegangenen Fokussierungskanals.

Gemäß einer weiteren Ausführungsform münden in die oder die weiteren Expansionskammern ein oder mehrere Zuführungskanäle zum Zuführen eines weiteren Fluids ein. Solche Fluide können einen die Mischung stabilisierenden Hilfsstoff, beispielsweise einen Emulgator, aufweisen. Die Zuführungskanäle sind vorteilhaft symmetrisch bezüglich einer Ebene, in der die Achse des Fokussierungskanals liegt, angeordnet.

Gemäß einer weiteren Ausführungsform weist die Expansionskammer einen oder mehrere weitere mit dieser in Verbindung stehende Auslasskanäle zum Ableiten der gebildeten Mischung auf. Die Auslasskanäle sind vorzugsweise in den Bereichen angeordnet, in denen sich stationäre Wirbel ausbilden. Auch hier sind die Auslasskanäle vorteilhaft symmetrisch bezüglich einer Ebene angeordnet, in der die Achse des Fokussierungskanals liegt.

Vorteilhaft weist die Expansionskammer eine derart angeordnete und ausgebildete Struktur auf, auf die der Fluidstrahl geleitet und abgelenkt wird. Diese Prallstruktur kann eine Ebene oder gebogene Fläche oder eine Struktur zum Ablenken und / oder Aufspalten des Fluidstrahls aufweisen. Vorteilhaft ist die Prallstruktur durch eine der Einmündung des Fokussierungskanals gegenüberliegenden Wand der Expansionskammer gebildet oder integrierter Bestandteil dieser.

Nach der Ausführungsform gemäß Anspruch 20 sind die Vielzahl benachbarter Fluidkanäle, die Einlasskammer in die die Fluidkanäle einmünden, und der mit der Einlasskammer fluidisch in Verbindung stehende Fokussierungskanal jeweils zwei oder mehrfach vorhanden und die zwei oder mehr Fokussierungskanäle münden in die eine gemeinsame Expansionskammer ein. Die Fokussierungskanäle sind hierbei vorteilhaft derart gegenüberliegend in die gemeinsame Expansionskammer einmündend angeordnet, dass die Fluidstrahlen in der Expansionskammer aufeinander treffen, wodurch der Mischeffekt weiter stark erhöht wird. Die zwei oder mehrfach vorhandene Vielzahl von benachbarten Fluidkanälen, Einlasskammern und Fokussierungskanälen sind räumlich voneinander getrennt angeordnet und lediglich über die gemeinsame Expansionskammer fluidisch miteinander in Verbindung kommt. Diese Strukturen können der Zuführung der gleichen Fluide, beispielsweise zweifach der Fluide A, B, oder aber auch unterschiedlicher Fluide, beispielsweise die Fluide A, B und C, D, dienen.

Gemäß einer bevorzugten Ausführungsform sind die Strukturen der Fluidkanäle, der Einlasskammer, des Fokussierungskanals und der Expansionskammer als Ausnehmungen und / oder Durchbrüche in einer als Mischerplatte dienenden Platte aus einem für die zu mischenden Fluide ausreichend inerten Material eingebracht. Diese offenen Strukturen sind durch eine mit der Mischerplatte fluidisch dicht verbundenen Deck- und / oder Bodenplatte abgeschlossen, wobei die Deck- und / oder Bodenplatte Zuführungen für die beiden Fluide und / oder mindestens eine Abführung für die gebildete Mischung aufweisen. Ausnehmungen, wie beispielweise Nuten oder Sacklöcher, sind in einer Ebene sowie senkrecht hierzu von Material umgeben. Durchbrüche, wie beispielsweise Schlitze oder Löcher, gehen dagegen durch das Material hindurch, d.h. sind nur an in einer Ebene seitlich von dem Material umgeben. Die Ausnehmungen und Durchbrüche werden durch die Deck- bzw. Bodenplatte abgedeckt unter Bildung von Fluidführungsstrukturen, wie Kanäle und Kammern. Die Zuführungen und / oder Abführungen in der Deck- oder Bodenplatte können durch Nuten und / oder Bohrungen realisiert sein.

Als geeignete Materialien kommen in Abhängigkeit von den verwendeten Fluiden unterschiedliche Materialien, wie beispielsweise Polymermaterialien, Metalle, Legierungen, Gläser, insbesondere fotostrukturierbares Glas, Quarzglas, Keramik oder Halbleitermaterialien, wie Silizium, in Frage. Bevorzugt sind Platten einer Stärke von 10 µm bis 5 mm, besonders bevorzugt von 50 µm bis 1 mm. Geeignete Verfahren zum fluidisch dichten Verbinden der Platten miteinander sind beispielsweise aneinander Pressen, Verwenden von Dichtungen, Kleben, thermisches oder anodisches Bonden und/ oder Diffusionsschweißen.

Weist der statische Mikrovermischer weitere Fokussierungskanäle und Expansionskammern auf, so befinden sich diese vorzugsweise auf der einen Mischerplatte. Es ist jedoch auch denkbar, dass diese auf einer oder mehreren weiteren Mischerplatten gebildet sind, die mit der ersten Mischerplatte und ggf. weiteren Mischerplatten fluidisch in Verbindung stehen.

Gemäß einer Variante dieser bevorzugten Ausführungsform weist der statische Mikrovermischer zwischen der Mischerplatte und der Bodenplatte eine mit diesen fluidisch dicht in Verbindung stehende Verteilerplatte zum getrennten Zuführen der Fluide von den Zuführungen in der Bodenplatte zu den Fluidkanälen der Mischerplatte auf. Hierzu weist die Verteilerplatte vorteilhaft je zuzuführendem Fluid eine Reihe von Löchern auf, wobei jedes Loch genau einem Fluidkanal zugeordnet ist. So dient bei zwei Fluiden die erste Reihe der Zuführung des ersten Fluids und die zweite Reihe der Zuführung des zweiten Fluids.

Vorzugsweise bestehen zumindest die Mischerplatte und die Deck- und/ oder Bodenplatte aus einem transparenten Werkstoff, insbesondere Glas oder Quarzglas. Besonders bevorzugt ist die Verwendung von fotostrukturierbarem Glas, das unter Anwendung fotolithographischer Verfahren eine präzise Mikrostrukturierung erlaubt. Weist der statische Mikrovermischer auch eine Verteilerplatte auf, so besteht diese vorzugsweise auch aus solch einem transparenten Werkstoff. Von besonderem Voteil ist hierbei, dass der in dem statischen Mikrovermischer ablaufende Mischvorgang von außen beobachtet werden kann.

Als Verfahren zur Strukturierung der Platten kommen bekannte feinwerk- und mikrotechnische Herstellungsverfahren in Frage, wie beispielsweise Laserablatieren, Funkenerodieren, Spritzgießen, Prägen oder galvanisches Abscheiden. Geeignet sind auch LIGA-Verfahren, die zumindest die Schritte des Strukturierens mit energiereicher Strahlung und galvanisches Abscheiden und ggf. Abformen umfassen.

Das erfindungsgemäße Verfahren und der statische Mikrovermischer werden vorteilhaft zur Durchführung chemischer Umsetzungen mit zwei oder mehr Edukten verwendet. Hierzu oder zu den zuvor genannten 'Verwendungen sind in den statischen Mikrovermischer vorteilhaft Mittel zur Steuerung der chemischen Umsetzung integriert, wie beispielsweise Temperatur- oder Drucksensoren, Durchflussmesser, Heizelemente oder Wärmetauscher. Diese Mittel können bei einem statischen Mikrovermischer gemäß Anspruch 20 auf der oder den selben Mischerplatten oder weiteren ober- und/ oder unterhalb angeordneten und mit diesen funktionell in Verbindung stehenden Platten angeordnet sein. Zur Durchführung heterogen katalysierter chemischer Umsetzungen kann der statische Mikrovermischer auch katalytisches Material aufweisen.

Nachfolgend werden Ausführungsformen des erfindungsgemäßen statischen Mikrovermischers an Hand von Zeichnungen exemplarisch erläutert. Es zeigen:
- Figur 1a: einen statischen Mikrovermischer, bestehend aus einer Deckplatte, Mischerplatte, Verteilerplatte und Bodenplatte jeweils von einander getrennt in perspektivischer Darstellung,
- Figur 1b: die Mischerplatte nach Figur 1 a in Draufsicht,
- Figur 2: eine Mischerplatte mit einem als Fokussierungskanal ausgebildeten Auslasskanal in Draufsicht,
- Figur 3: eine Mischerplatte mit mehreren hintereinander angeordneten Fokussierungskanälen und Expansionskammern in Draufsicht,
- Figur 4: eine Mischerplatte mit einer Mischkammer mit Zuführ- und Auslasskanälen in Draufsicht,
- Figur 5: eine Mischerplatte mit einer in der Expansionskammer angeordneten Prallstruktur in Draufsicht,
- Figur 6: eine Mischerplatte mit einer durch die Mischkammerwand gebildeten Prallstruktur in Draufsicht,
- Figur 7: eine Mischerplatte gemäß Figur 6 jedoch mit seitlich angeordneten Auslasskanälen in Draufsicht,
- Figur 8: eine Mischerplatte gemäß Figur 7 mit zusätzlichen Zuführkanälen in Draufsicht,
- Figur 9: eine Mischerplatte mit zwei gegenüberliegenden in eine gemeinsame Expansionskammer einmündenden Fokussierungskanälen in Draufsicht,
- Figur 10 a: eine lichtmikroskopische Aufnahme eines statischen Mikrovermsichers gemäß Figur 1 a während des Mischvorgangs einer gefärbten mit einer farblosen Flüssigkeit bei einem Volumenstrom von je 100 ml / h,

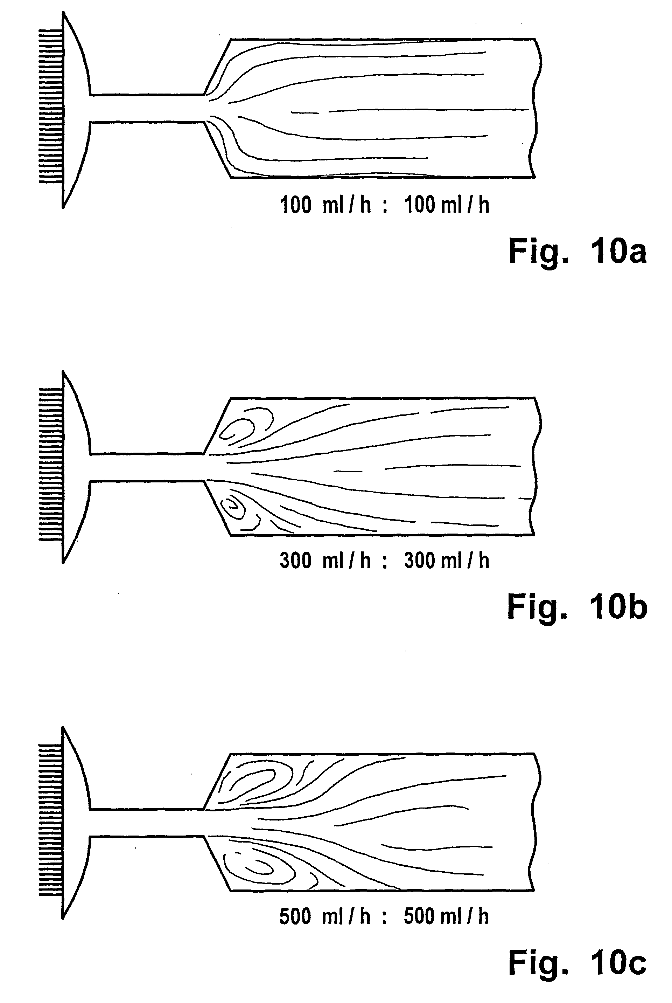

- Figur 10 b: Aufnahme wie Figur 10 a jedoch bei 300 ml / h,
- Figur 10c: Aufnahme wie Figur 10 a jedoch bei 500 ml / h.

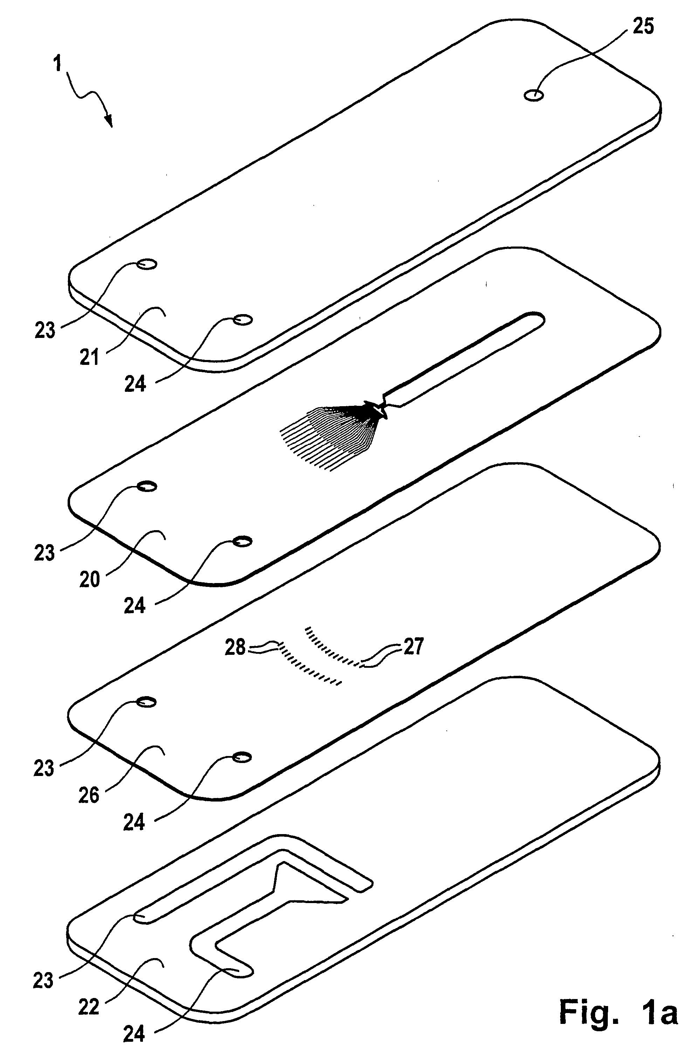

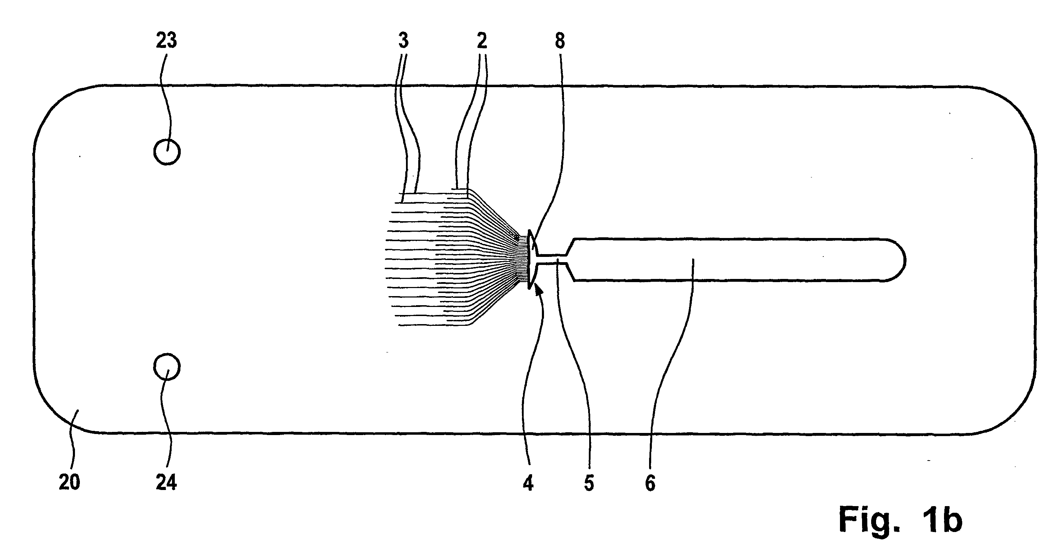

Die Figur 1 a zeigt einen statischen Mikrovermischer 1 mit einer Deckplatte 21, einer Mischerplatte 20, einer Verteilerplatte 26 und eine Bodenplatte 22 jeweils von einander getrennt in perspektivischer Darstellung.

Die Deckplatte 21, die Mischerplatte 20 und die Verteilerplatte 26 weisen jeweils eine Zuführung 23 für das Fluid A und eine Zuführung 24 für das Fluid B in Form einer Bohrung auf. Die Bohrungen sind derart angeordnet, dass beim Übereinanderstapeln der Platten die Zuführungen 23, 24 mit den Zuführungsstrukturen 23, 24 der Bodenplatte 22 fluidisch in Verbindung stehen. Die Zuführung 23 für das Fluid A und die Zuführung 24 für das Fluid B sind in Form von Nuten derart auf der Bodenplatte 22 angeordnet, dass das Fluid A zu der Verteilerstruktur 27 und das Fluid B zu der Verteilerstruktur 28 der darüber liegenden Verteilerplatte 26 ohne wesentliche Druckverluste geleitet werden kann. Die Verteilerplatte 26 weist eine Verteilerstruktur 27 für das Fluid A und eine Verteilerstruktur 28 für das Fluid B jeweils in Form einer Reihe von durch die Platte hindurchgehenden Löchern auf.

Die in Figur 1 b in der Draufsicht im Detail gezeigte Mischerplatte 20 weist Fluidkanäle 2,3, eine Einlasskammer 4, einen Fokussierungskanal 5 und eine Expansionskammer 6 auf. Die Abführung 25 in Form einer Bohrung in der Deckplatte 21 ist derart angeordnet, dass beim Übereinanderstapeln der Platten die Abführung 25 mit der Expansionskammer 6 der Mischerplatte 20 fluidisch in Verbindung steht. Die Kanäle 2 für das Fluid A weisen eine kleinere Länge als die Kanäle 3 für das Fluid B auf. Die Kanäle 2, 3 sind in ihrer von der Einlasskammer 4 abgewandten Seite parallel zueinander ausgerichtet, wobei die Kanäle 2 für das Fluid A abwechselnd benachbart mit den Kanälen 3 für das Fluid B liegen. In einem Übergangsbereich verringert sich der Abstand der Kanäle untereinander in Richtung Einlasskammer 4. Im Bereich der Einmündung in die Einlasskammer 4 sind die Kanäle 2, 3 wiederum parallel zueinander ausgerichtet. Um einen gleichmäßigen Volumenstrom über aller Kanäle 2, 3 für jeweils ein Fluid zu erreichen, weisen die Kanäle 2, 3 jeweils untereinander die gleiche Länge auf. Dies führt dazu, dass die von der Eintrittskammer 4 entfernt liegenden Enden der Fluidkanäle 2, 3 jeweils auf einem Bogen liegen. Die Bohrungen der Verteilerstrukturen 27,28 der Verteilerplatte 26 sind ebenfalls jeweils in einem Bogen derart angeordnet, dass die Enden der Kanäle 2, 3 jeweils fluidisch mit einer Bohrung kontaktiert werden. Die Einlasskammer 4, in die die Fluidkanäle 2, 3 einmünden, weist in der Ebene der Fluidkanäle eine halbkonkave Form auf. Im mittleren Bereich der konkaven Fläche 8, die den Einmündungen der Fluidkanäle 2, 3 gegenüberliegt, geht die Einlasskammer 4 in den Fokussierungskanal 5 über. Der Fokussierungskanal 5 mündet in die Expansionskammer 6 ein, die von einem im Vergleich mit dem Fokussierungskanal 5 breiteren und sich in Längsstreckung zu diesem angeordneten Kanal gebildet ist. Die Strukturen der Fluidkanäle 2, 3, der Einlasskammer 4, des Fokussierungskanals 5 und der Expansionskammer 6 sind durch das Material der Mischerplatte 20 hindurchgehende Durchbrüche gebildet. Durch die darunterliegende Verteilerplatte 26 und die darüberliegende Deckplatte 21 werden diese zu zwei Seiten hin offenen Strukturen unter Bildung von Kanälen bzw. Kammern abgedeckt.

Beim betriebsfertigen Mikrovermischer 1 sind die hier voneinander getrennt dargestellten Platten 21, 20, 26 und 22 übereinander gestapelt und fluidisch dicht miteinander verbunden, wodurch die offenen Strukturen, wie Nuten 23, 24 und Durchbrüche 2, 3, 4, 5 und 6, unter Bildung von Kanälen und Kammern abgedeckt sind. Der so erhaltene Stapel aus den Platten 21, 20, 26 und 22 kann in ein Mischergehäuse aufgenommen sein, das geeignete fluidische Anschlüsse für die Zuführung von zwei Fluiden und die Abführung des Fluidgemischs aufweist. Darüber hinaus kann durch das Gehäuse eine Anpresskraft auf den Plattenstapel zum fluidisch dichten Verbinden aufgebracht werden. Es ist auch denkbar, den Plattenstapel als Mikrovermischer 1 ohne Gehäuse zu betreiben, wozu mit den Zuführungen 23, 24 und der Abführung 25 der Deckplatte 21 vorteilhaft fluidische Anschlüsse, beispielsweise Schlauchtüllen, verbunden sind.

Beim eigentlichen Mischvorgang wird in die Zuführungsbohrung 23 und in die Zuführungsbohrung 24 der Deckplatte 21 jeweils ein Fluid A und ein Fluid B eingeleitet. Diese Fluide strömen jeweils durch die Zuführungsstrukturen 23 und 24 der Platten 20, 26 und 22 und werden von dort gleichmäßig jeweils in die als Bohrungen ausgebildeten Verteilerstrukturen 27 und 28 verteilt. Von den Bohrungen der Verteilerstruktur 27 strömt das Fluid A in die exakt darüber angeordneten Kanäle 2 der Mischerplatte 20. Ebenso gelangt das Fluid B von den Bohrungen der Verteilerstruktur 28 in die exakt darüber angeordneten Kanäle 3. Die in den Fluidkanälen 2, 3 getrennt geführten Fluidströme A, B werden in der Einlasskammer 4 zusammengeführt unter Bildung abwechselnd benachbarter Fluidlamellen der Folge ABAB. Bedingt durch die halbkonkave Form der Einlasskammer 4 werden die vereinigten Fluidströme rasch in den Fokussierungskanal 5 überführt. Der so gebildete fokussierte Gesamtfluidstrom wird in die Expansionskammer 6 als Fluidstrahl eingeleitet. Die gebildete Mischung der Fluide A, B wird durch die sich über dem Endbereich der Expansionskammer 6 befindliche Abführungsbohrung 25 der Deckplatte 21 abgeleitet.

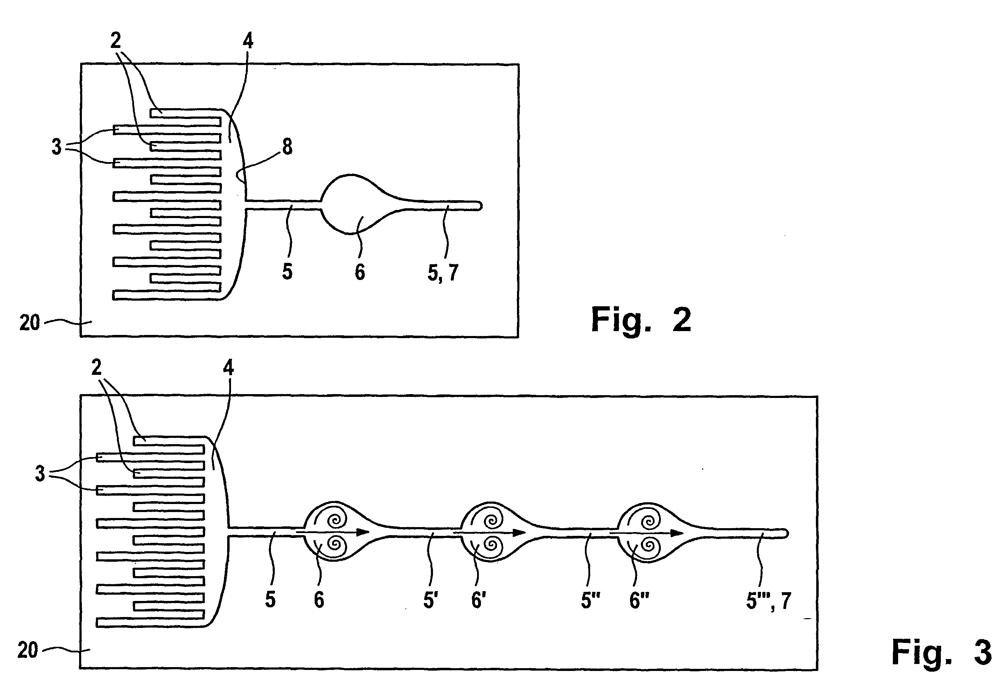

Die Figur 2 zeigt eine Mischerplatte 20 in Draufsicht, wobei die zuführenden Fluidkanäle 2,3 für die Fluide A und B gegenüber der Figur 1 b vereinfacht dargestellt sind. Die Einlasskammer 4 weist eine halbkonkave Form auf, wobei die konkave Fläche 8 den Einmündungen der Kanäle 2,3 gegenüber liegt. Die Einlasskammer 4 geht im Bereich der Mitte der konkaven Fläche 8 in den Fokussierungskanal 5 über. Der Fokussierungskanal 5 weist über seine gesamte Länge eine gleiche Breite auf und mündet in die Expansionskammer 6 ein. Die Expansionskammer 6 geht gegenüberliegend dem Fokussierungskanal 5 in einen weiteren Fokussierungskanal 5' der als Auslasskanal 7 dient, über. Die Expansionskammer 6 weist in Draufsicht eine im wesentlichen kreisrunde Form auf, die in Richtung des weiteren Fokussierungskanals 5' aufgeweitet ist. Durch diese Form besitzt die Expansionskammer 6 in ihrem Innern in der gezeigten Ebene eine an die Ausbildung von stationären Wirbeln angepasste Form. Dies vermeidet Totwasserbereiche, so dass alle Bereiche der Expansionskammer 6 ständig durchströmt werden.

Die aus den Kanälen 2,3 austretenden Fluidströme der Fluide A und B werden in der Einlasskammer 4 zusammengeführt und, bedingt durch die halbkonkave Form, rasch als vereinigter Fluidlamellenstrom in den Fokussierungskanal 5 überführt. Bedingt durch den deutlich engeren Querschnitt des Fokussierungskanals 5 im Vergleich zur Einlasskammer 4 wird eine Fokussierung des Fluidstroms, d.h. eine Verringerung der Fluidlamellenbreite bei gleichzeitiger Erhöhung der Fließgeschwindigkeit erreicht. Der so fokussierte Gesamtfluidstrom tritt als Fluidstrahl 5 in die Expansionskammer 6 ein und erfährt dort eine seitliche Aufweitung, wobei sich zu beiden Seiten des Fluidstrahls Wirbel ausbilden können. Das in der Expansionskammer 6 erzielte Mischprodukt wird unter erneuter Fokussierung in dem weiteren Fokussierungskanal 5' abgeleitet. Das erzielte Fluidgemisch wird am Ende des weiteren Fokussierungskanal 5' nach oben in eine sich über der Mischerplatte 20 befindenden Deckplatte abgeleitet.

Die in Figur 3 in Draufsicht gezeigte Mischerplatte 20 weist eine Folge von mehreren hintereinander angeordneten Expansionskammern 6, 6', 6" und Fokussierungskanälen 5, 5', 5", 5'" auf. Die Ausgestaltung und Form der zuführenden Fluidkanäle 2, 3, der Einlasskammer 4, des Fokussierungskanals 5 und der Expansionskammer 6 sind gleich zu den entsprechenden Strukturen der in der Figur 2 zuvor gezeigten Mischerplatte. Die Expansionskammer 6 geht gegenüberliegend des Fokussierungskanals 5 in einen weiteren Fokussierungskanal 5' über, der sich in Längserstreckung des Fokussierungskanals 5 befindet. Dieser weitere Fokussierungskanal 5' mündet wiederum in eine weitere Wirbelkammer 6' ein, die wiederum in einen weiteren Fokussierungskanal 5'" übergeht. Hieran schließt sich eine dritte Expansionskammer 6'" an, die schließlich in den als Auslasskanal 7 dienenden weiteren Fokussierungskanal 5'" übergeht. Die Fokussierungskanäle 5, 5', 5", 5"' weisen eine im wesentlichen gleiche Länge auf und sind in Längserstreckung zueinander mit dazwischen befindlichen Expansionskammern 6, 6', 6" angeordnet. In den Expansionskammern 6, 6', 6" ist der Verlauf des Fluidstrahls mit einem Pfeil angedeutet. Zu beiden Seiten des Fluidstrahls bilden sich hier durch spiralförmige Linien angedeutete stationäre Wirbel aus. Der hinter einer Expansionskammer angeordnete Fokussierungskanal erfasst somit zumindest einen Teil des in die Expansionskammer eintretenden Fluidstrahls als auch ein Teil des erzielten Mischprodukts. Durch das wiederholte Fokussieren und Einleiten in eine weitere Expansionskammer können Mischungen, insbesondere Emulsionen und Dispersionen, hoher Güte in kurzer Mischzeit erhalten werden.

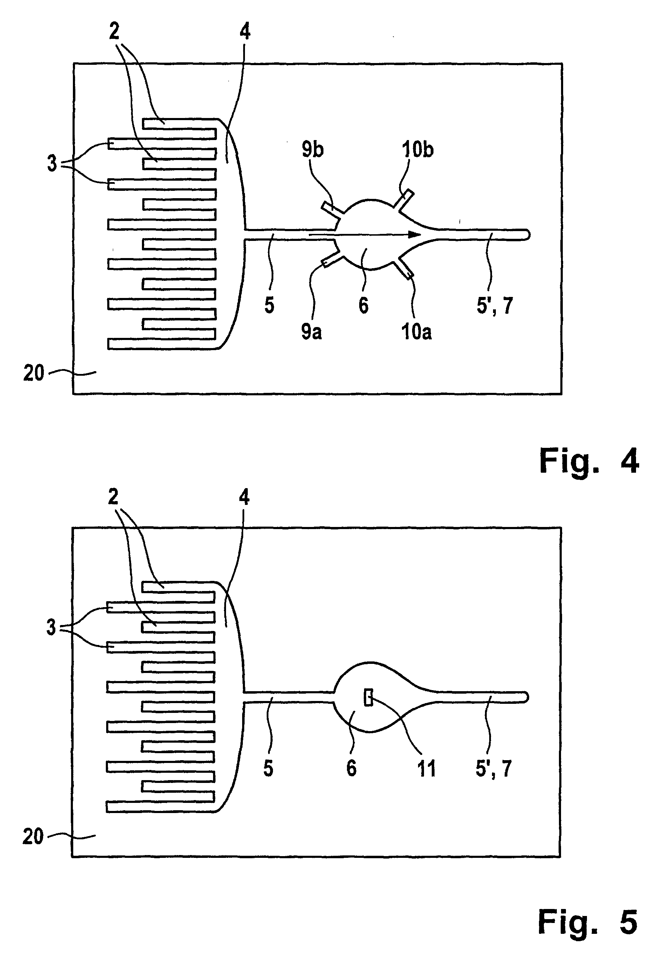

In Figur 4 ist die Mischerplatte 20 eines weiteren erfindungsgemäßen statischen Mikrovermischers in Draufsicht gezeigt. Die Ausgestaltung und Anordnung der Kanäle 2,3, der Eintrittskammer 4, des Fokussierungskanals 5, der Expansionskammer 6 und des als Auslass 7 dienenden weiteren Fokussierungskanals 5' entsprechen denen, der in Figur 2 dargestellten Strukturen. In die Expansionskammer 6 münden auf der Seite, in die der Fokussierungskanal 5 eintritt, und symmetrisch hierzu angeordnet, zwei Zuführkanäle 9a, 9b. Mittels dieser Zuführkanäle 9a, 9b kann in den Bereich der gebildeten Wirbel in der Expansionskammer 6 ein weiteres Fluid, beispielsweise ein Emulgator eingeleitet werden. Darüber hinaus stehen mit der Expansionskammer 6 zwei weitere Auslasskanäle 10a, 10b in Verbindung, die auf der Seite, in die die Expansionskammer 6 in den weiteren Fokussierungskanal 5' übergeht, und symmetrisch zu dem weiteren Fokussierungskanal 5', angeordnet sind. Mittels dieser weiteren Auslasskanäle 10a, 10b kann ein Teil der gebildeten Mischung aus der Expansionskammer 6 abgezogen werden. Hierzu stehen die Zuführkanäle 9a, 9b und die weiteren Auslasskanäle 10a, 10b fluidisch mit entsprechenden Zuführ- bzw. Abführstrukturen in der sich darüber befindenden Deck- und / oder Bodenplatte in Verbindung. Die Anordnung der Zuführkanäle 9a, 9b und der weiteren Auslasskanäle 10a, 10b ist hier nur beispielhaft gezeigt. So können sich entsprechende Zuführ- und / oder Auslasskanäle auch im Bereich der Bodenplatte und / oder Deckplatte unterhalb bzw. oberhalb der Expansionskammer 6 befinden. Je nach Anwendung kann es von Vorteil sein, wenn in die Expansionskammer 6 nur ein oder mehrere Zuführkanäle oder nur ein oder mehrere Auslasskanäle einmünden.

Die Figur 5 zeigt in Draufsicht eine Mischerplatte 20 eines weiteren erfindungsgemäßen statischen Mikrovermischers mit Strukturen, wie in Figur 2 gezeigt, wobei sich zusätzlich in der Expansionskammer 6 eine Prallstruktur 11 befindet. Die Prallstruktur 11 ist durch eine sich in der Expansionskammer 6 befindliche quaderförmige Struktur gebildet, wobei eine Fläche des Quaders sich gegenüber und beabstandet zu der Einmündung des Fokussierungskanals 5 befindet. Hierdurch wird erzielt, dass der als Fluidstrahl in die Expansionskammer 6 austretende fokussierte Gesamtfluidstrom auf die Prallstruktur 11 trifft und dort unter Wirbelbildung zu beiden Seiten in die Expansionskammer 6 abgeleitet wird. Hierdurch wird eine besonders innige Mischung mit sehr kurzen Mischzeiten erzielt. Die gebildete Mischung wird über den als Auslasskanal 7 dienenden weiteren Fokussierungskanal 5' abgeleitet.

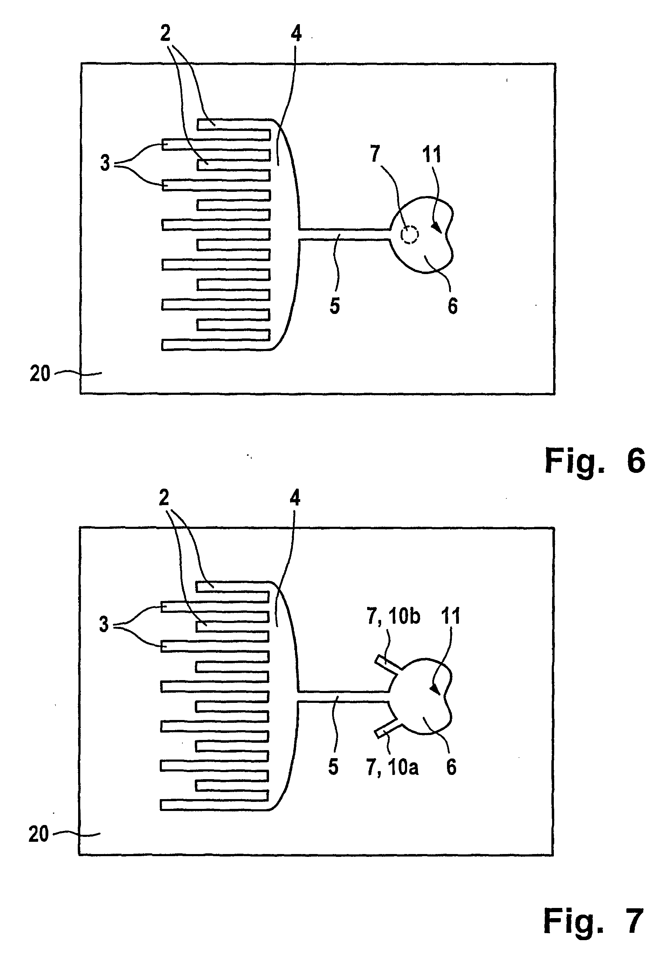

Eine Mischerplatte 20 einer weiteren Ausführungsform des erfindungsgemäßen statischen Mikrovermischers ist in Figur 6 in Draufsicht dargestellt. Die Anordnung der Fluidkanäle 2, 3, der Einlasskammer 4 und des Fokussierungskanals 5 entspricht der Figur 2. Der Fokussierungskanal 5 geht in eine Expansionskammer 6 über, die in der dargestellten Ebene keinen Auslasskanal aufweist. Die Expansionskammer 6 weist in der gezeigten Ebene eine im wesentlichen runde Gestalt auf, wobei die dem Fokussierungskanal 5 gegenüberliegende Fläche in die Expansionskammer hineingewölbt ist. Hierdurch wird erzielt, dass der aus dem Fokussierungskanal 5 in die Expansionskammer 6 austretende Fluidstrahl auf den Bereich der ausgewölbten Fläche, die als Prallstruktur 11 dient, trifft und zu beiden Seiten in die Expansionskammer 6 abgeleitet wird. Die so erzielte Mischung wird durch einen sich in der hier nicht dargestellten Deckplatte befindlichen Auslasskanal 7 abgeleitet, der hier als Kreis mit gestrichelter Linie dargestellt ist.

Die Figur 7 zeigt eine Ausführungsvariante der Mischerplatte 20 des in Figur 6 dargestellten statischen Mikrovermischers. Auch hier besitzt die Expansionskammer 6 eine durch einen in die Kammer ausgewölbten Bereich der Wand der Expansionskammer 6 gebildeten Prallstruktur 11. In die Expansionskammer 6 münden zwei Auslasskanäle 10a, 10b. Diese Auslasskanäle befinden sich im wesentlichen gegenüberliegend der Prallstruktur 11 und sind symmetrisch zu der Achse des Fokussierungskanals 5 angeordnet. Im Vergleich zu Figur 6 wird die erzielte Mischung somit nicht nach oben aus der Expansionskammer sondern seitlich aus den Bereichen der Wirbelbildung abgeleitet.

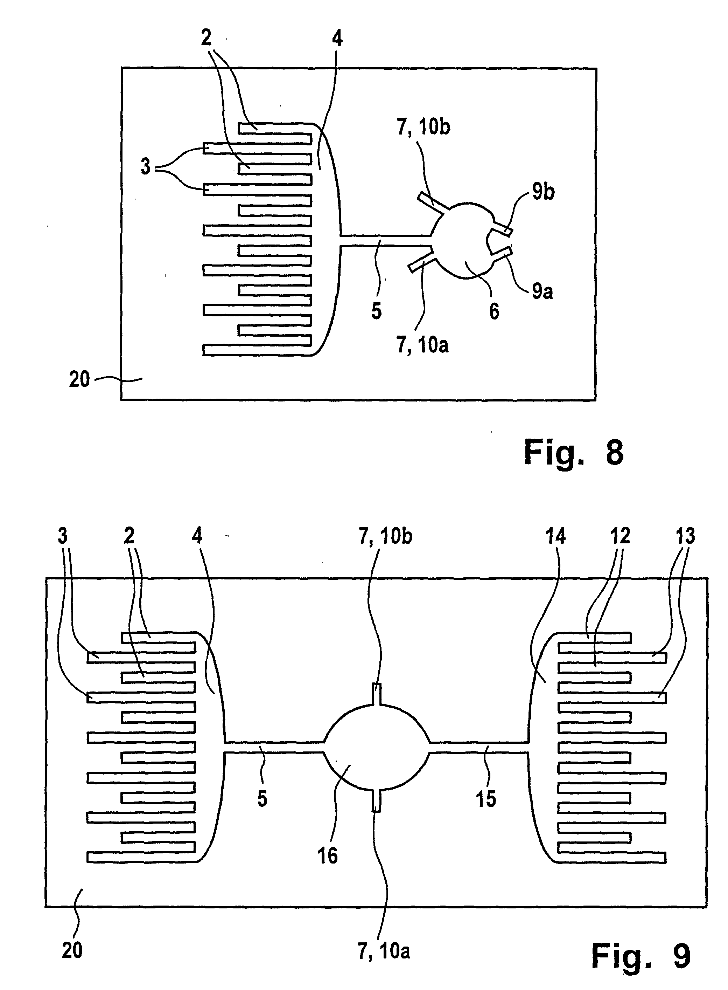

In der Figur 8 ist eine Variante der in der Figur 7 gezeigten Ausführungsform dargestellt. In die Expansionskammer 6 münden zusätzlich zu den weiteren Auslasskanälen 10a, 10b zwei Zuführkanäle 9a, 9b ein. Diese Zuführkanäle sind zu beiden Seiten der Prallstruktur 11 und an diese angrenzend sowie symmetrisch zu der durch den Fokussierungskanal 5 gebildeten Achse angeordnet. Wie auch zu Figur 4 beschrieben, können diese Zuführkanäle der Zuführung eines die Mischung, insbesondere die Emulsion oder Dispersion, unterstützenden Fluids, beispielsweise der Zuführung eines Emulgators, dienen. Die weiteren Auslasskanäle 10a, 10b und die Zuführkanäle 9a, 9b stehen mit entsprechenden Zuführ- bzw. Auslasstrukturen in der Boden- und / oder Deckplatte fluidisch in Verbindung.

Eine Mischerplatte 20 einer weiteren Ausführungsform des statischen Mikrovermischers ist in der Figur 9 in Draufsicht dargestellt. In eine gemeinsame Expansionskammer 16 münden gegenüberliegend von zwei Seiten zwei Fokussierungskanäle 5, 15 ein. Diese Fokussierungskanäle 5, 15 stehen in Verbindung jeweils mit einer Einlasskammer 4, 14, in die die Fluidkanäle 2,3; 12,13 einmünden. Die beiden Fokussierungskanäle 5,15 sind in Längserstreckung zueinander angeordnet. Senkrecht hierzu und in gleicher Ebene mündet jeweils zu beiden Seiten ein Auslasskanal 10 a, 10 b in die Expansionskammer 16. Sowohl in der Einlasskammer 4 als auch in der Einlasskammer 14 werden die aus den Fluidkanälen 2,3; 12,13 austretenen Fluidströme vereinigt und rasch unter Fokussierung in den Fokussierungskanal 5, 15 geleitet. Die so vereinigten und fokussierten Fluidlamellenströme treten aus den Fokussierungskanälen 5,15 jeweils als Fluidstrahl von gegenüberliegenden Seiten in die gemeinsame Expansionskammer 16 ein und treffen dort unter Wirbelbildung aufeinander, wodurch in kürzester Zeit eine innige Mischung erzielt wird. Das erzielte Mischprodukt wird zu beiden Seiten aus der gemeinsamen Expansionskammer 16 über die Auslasskanäle 10a, 10b, die mit entsprechenden Strukturen in der Boden- und / oder Deckplatte fluidisch in Verbindung stehen, abgeleitet.

### Ausführungsbeispiel

Der in den Figuren 1 a und 1 b dargestellte statische Mikrovermischer wurde mittels mikrostrukturierter Glasplatten realisiert. Die Mischerplatte 20 und die Verteilerplatte 26 wiesen jeweils eine Stärke von 150 µm und die abschließenden Bodenplatte 22 und Deckplatte 21 jeweils eine Stärke von 1 mm auf. Als Zuführungen 23, 24 in der Deckplatte 21, der Mischerplatte 20 und der Verteilerplatte 26 wurden Bohrungen mit einem Durchmesser von 1,6 mm gewählt. Die Verteilerplatte 26 wies als Verteilerstrukturen 27, 28 zwei Reihen von je 15 Langlöchern einer Länge von 0,6 mm und einer Breite von 0,2 mm auf. Die Fluidkanäle 2, 3 der Mischerplatte 20 wiesen eine Breite von 60 µm bei einer Länge von 11,3 mm bzw. einer Länge von 7,3 mm auf. Im Bereich der Einmündung der Kanäle 2,3 in die Einlasskammer 4 wiesen die sich zwischen den Kanälen 2,3 befindenden Stege eine Breite von 50 µm auf. Die Breite der Einlasskammer 4 im Bereich der Einmündung der Fluidkanäle 2, 3 reduzierte sich von 4,3 mm hin zur gegenüberliegenden Seite auf eine Breite des Fokussierungskanals von 0,5 mm. Da alle Strukturen der Mischerplatte 20 als Durchbrüche realisiert wurden, weisen die Fluidkanäle 2, 3, die Einlasskammer 4, der Fokussierungskanal 5 und die Expansionskammer 6 eine Tiefe auf, die gleich der Stärke der Mischerplatte von 150 µm ist. Die Länge der Einlasskammer 4, d.h. der Abstand zwischen der Einmündung der Fluidkanäle 2, 3 und der Einmündung des Fokussierungskanals 5, betrug nur 2,5 mm, um ein rasches Ableiten und Fokussieren der vereinigten Fluidströme zu ermöglichen. Das Verhältnis der Querschnittsfläche des Fokussierungskanals zu der Summe der Querschnittsflächen der Fludikanäle 2, 3 betrug damit 1 zu 3,6. Mit einer Länge von 2,5 mm des Fokussierungskanals 5 wurde ein Verhältnis von Länge zu Breite von 5 zu 1 erzielt. Der Fokussierungskanal 5 ging in Längserstreckung in die kanalartig ausgebildete Expansionskammer 6 einer Länge von 24,6 mm und einer Breite von 2,8 mm über. Der Öffnungwinkel der Seitenflächen der Expansionskammern 6 im Übergangsbereich zwischen der Expansionskammer 6 und des Fokussierungskanals 5 betrug 126,7°. Die vier in der Figur 1 a dargestellten Platten besaßen eine Aussenabmessung von 26 x 76 mm. Die Platten wurden fotolithographisch unter Verwendung von fotostrukturierbarem Glas mittels eines bekannten Verfahrens strukturiert, wie es von Th. R. Dietrich, W. Ehrfeld, M. Lacher und B. Speit in Mikrostrukturprodukte aus fotostrukturierbarem Glas, F&M 104 (1996) auf den Seiten 520 bis 524 beschrieben wurde. Die Platten wurden durch thermisches Bonden fluidisch dicht miteinander verbunden.

Die Realisierung aller Komponenten des statischen Mikrovermsichers in Glas gestattete eine Beobachtung des Mischvorgangs unter einem Lichtmikroskop, wie es die entsprechenden Aufnahmen der Figuren 10a, 10b und 10c bei Beleuchtung von unten zeigen. Hierzu wurde der Vorgang der Emulsionsbildung von Silikonöl mit Wasser, das einen blauen Farbstoff aufwies, untersucht. Die Figuren 10 a bis 10 c zeigen lediglich den Ausschnitt der Einmündungen der Fluidkänäle 2, 3 in die Einlasskammer 4, den Fokussierungskanal 5 und die Expansionskammer 6.

Die das mit dem Farbstoff versetzte Wasser führenden Fluidkanäle sind im linken Einmündungsbereich in die Einlasskammer an ihrem dunkleren Grauton deutlich zu erkennen. Da sowohl das zugeführte Silikonöl als auch die zwischen den Fluidkanälen 2, 3 vorhandenen Stege aus Glas transparent sind, sind diese hier nicht voneinander zu unterscheiden.

Bei allen drei Aufnahmen ist deutlich das Zusammenführen der getrennten Fluidströme und das Abführen der vereinigten Fluidströme unter Fokussierung zu erkennen. Hierbei wird die Fluidlamellenstruktur beibehalten.

In der Figur 10a, die bei einem Volumenstrom von 100 ml / h jeweils für Silikonöl und Wasser aufgenommen wurde, ist ein rasches Aufweiten des Gesamtfluidstroms beim Eintritt in die Expansionskammer zu erkennen.

In der Figur 10b, die bei Volumenströmen von je 300 ml / h aufgenommen wurde, erkennt man deutlich die Ausbildung eines Fluidstrahls beim Eintritt in die Expansionskammer, der sich später auffächert. Zu beiden Seiten des Fluidstrahls bilden sich Wirbel in der Expansionskammer aus.

Am deutlichsten ist die Bildung stationärer Wirbel zu beiden Seiten des in die Expansionskammer 6 eintretenden Fluidstrahls in Figur 10c zu erkennen, die bei Volumenströmen von je 500 ml / h aufgenommen wurde.

### Bezugszeichenliste

- 1: Statischer Mikrovermischer
- 2: Fluidkanal für Fluid a
- 3: Fluidkanal für Fluid b
- 4: Einlasskammer
- 5: Fokussierungskanal
- 5', 5", ..,: weiterer Fokussierungskanal
- 6: Expansionskammer
- 6', 6", ...: weitere Expansionskammer
- 7: Auslasskanal
- 8: Konkave Fläche
- 9 a, 9 b: Zuführkanal
- 10 a, 10 b: Weitere Auslasskanäle
- 11: Prallstruktur
- 12: Fluidkanal für Fluid a
- 13: Fluidkanal für Fluid b
- 14: Einlasskammer
- 15: Fokussierungkanal
- 16: Gemeinsame Expansionskammer
- 20: Mischerplatte
- 21: Deckplatte
- 22: Bodenplatte
- 23: Zuführung für Fluid a
- 24: Zuführung für Fluid b
- 25: Abführung
- 26: Verteilerplatte
- 27: Verteilerstruktur für Fluid a
- 28: Verteilerstruktur für Fluid b

## Patentansprüche

1. Verfahren zum Mischen mindestens zweier Fluide mit den Schritten:
- Zusammenführen einer Vielzahl getrennter Fluidströme der beiden Fluide jeweils einer Breite im Bereich von 1 µm bis 1 mm und einer Tiefe im Bereich von 10 µm bis 10 mm unter Bildung abwechselnd benachbarter Fluidlamellen der beiden Fluide,
- Abführen der vereinigten Fluidströme unter Ausbildung eines fokussierten Gesamtfluidstroms,
**gekennzeichnet durch** die Schritte
- Einleiten des fokussierten Gesamtfluidstroms als Fluidstrahl in eine Expansionskammer (6) mit einer zum fokussierten Gesamtfluidstrom größeren Querschnittsfläche senkrecht zur Strömungsrichtung des fokussierten Gesamtfluidstroms,
- Ableiten der gebildeten Mischung.

2. Verfahren nach Anspruch 1, **dadurch gekennzeichnet, dass** die vereinigten Fluidströme derart fokussiert werden, dass das Verhältnis der Querschnittsfläche des fokussierten Gesamtfluidstroms zu der Summe der Querschnittsflächen der zusammenzuführenden Fluidströme jeweils senkrecht zur Strömungsrichtung im Bereich von 1 : 1,5 bis 1 : 500, vorzugsweise im Bereich von 1 : 2 bis 1 : 50, liegt.

3. Verfahren nach einem der Ansprüche 1 oder 2, **dadurch gekennzeichnet, dass** das Verhältnis der Länge des fokussierten Gesamtfluidstroms zu seiner Breite im Bereich von 1 : 1 bis 30 : 1, vorzugsweise im Bereich von 1,5 : 1 zu 10 : 1, liegt.

4. Verfahren nach einem der vorherigen Ansprüche, **dadurch gekennzeichnet, dass** der fokussierte Gesamtfluidstrom derart als Fluidstrahl in die Expansionskammer (6) eingeleitet wird, dass sich zumindest in einer Ebene zu beiden Seiten des Fluidstrahls stationäre Wirbel bilden.

5. Verfahren nach einem der vorherigen Ansprüche, **dadurch gekennzeichnet, dass** zumindest ein Teil des Fluidstroms nach dem Einleiten in die Expansionskammer (6) erneut unter Fokussierung abgeleitet wird.

6. Verfahren nach einem der vorherigen Ansprüche, **gekennzeichnet durch** ein ein- oder mehrfach wiederholtes Durchführen der folgenden beiden Verfahrensschritte
- Abführen zumindest eines Teils des Fluidstroms nach dem vorhergehenden Einleiten in die Expansionskammer (6) unter Ausbildung eines fokussierten Fluidstroms,
- Einleiten des fokussierten Fluidstroms in eine weitere Expansionskammer (6', 6") mit einer zum fokussierten Fluidstrom größeren Querschnittsfläche senkrecht zur Strömungsrichtung des fokussierten Fluidstroms,
wobei die gebildete Mischung nach dem letzten Schritt abgeleitet wird.

7. Verfahren nach einem der vorherigen Ansprüche, **dadurch gekennzeichnet, dass** in die Expansionskammer ein weiteres Fluid, beispielsweise ein einen die Mischung stabilisierenden Hilfsstoff aufweisendes Fluid, eingeleitet wird.

8. Verfahren nach einem der vorherigen Ansprüche, **dadurch gekennzeichnet, dass** aus dem oder den Bereichen der Expansionskammer mit Wirbelbildung zumindest ein Teil der gebildeten Mischung abgeleitet wird.

9. Verfahren nach einem der vorherigen Ansprüche, **dadurch gekennzeichnet, dass** die ersten beiden Verfahrensschritte jeweils gleichzeitig und räumlich voneinander getrennt zwei- oder mehrfach durchgeführt werden und die so erhaltenen zwei oder mehr fokussierten Gesamtfluidströme in die gemeinsame Expansionskammer eingeleitet werden.

10. Statischer Mikrovermischer (1) zum Mischen mindestens zweier Fluide mit
einer Vielzahl abwechselnd benachbarter Fluidkanäle (2, 3) einer Breite im Bereich von 1 µm bis 1 mm und einer Tiefe im Bereich von 10 µm bis 10 mm zur getrennten Zuführung der Fluide als Fluidströme,
einer Einlasskammer (4), in die die Fluidkanäle einmünden,
einem mit der Einlasskammer (4) fluidisch in Verbindung stehenden Fokussierungskanal (5) zum Abführen der in der Einlasskammer (4) vereinigten Fluidströme unter Ausbildung eines fokussierten Gesamtfluidstroms,
**gekennzeichnet durch**
eine Expansionskammer (6), in die der Fokussierungskanal (5) einmündet und der fokussierte Gesamtfluidstrom als Fluidstrahl eintreten kann, mit einer zum Fokussierungskanal (4) größeren Querschnittsfläche senkrecht zur Achse des Fokussierungskanals (4) und
mindestens einem mit der Expansionskammer (6) fluidisch in Verbindung stehenden Auslasskanal (7) zum Ableiten der gebildeten Mischung.

11. Statischer Mikrovermischer nach Anspruch 10, **dadurch gekennzeichnet, dass** die Einlasskammer (4) in ihrem Innern zumindest in einer Ebene eine konkave oder halbkonkave Form aufweist, mit der konkaven Fläche (8), in die der

12. Statischer Mikrovermischer nach Anspruch 10 oder 11, **dadurch gekennzeichnet, dass** das Verhältnis der Querschnittsfläche des Fokussierungskanals (5) zu der Summe der Querschnittsflächen der in die Einlasskammer (4) einmündenden Fluidkanäle (2, 3) jeweils senkrecht zur Kanalachse im Bereich von 1 : 1,5 bis 1 : 500, vorzusweise im Bereich von 1 : 2 bis 1 : 50, liegt.

13. Statischer Mikrovermischer nach einem der Ansprüche 10 bis 12, **dadurch gekennzeichnet, dass** das Verhältnis der Länge des Fokussierungskanals (5) zu seiner Breite im Bereich von 1 : 1 bis 30 : 1, vorzugsweise im Bereich von 1,5 : 1 zu 10 : 1, liegt.

14. Statischer Mikrovermischer nach einem der Ansprüche 10 bis 13, **dadurch gekennzeichnet, dass** das Verhältnis der Querschnittsfläche der Expansionskammer (6) in zumindest einem mittleren Bereich zu der Querschnittsfläche des in die Expansionskammer einmündenden Fokussierungskanals (5) senkrecht zur Kanalachse im Bereich von 1,5 : 1 bis 500 : 1, vorzugsweise im Bereich von 2 : 1 bis 50 : 1, liegt.

15. Statischer Mikrovermischer nach einem der Ansprüche 10 bis 14, **dadurch gekennzeichnet, dass** die Expansionskammer (6) in einen weiteren, als Auslasskanal (7) dienenden Fokussierungskanal (5') übergeht zum Ableiten und erneuten Fokussieren zumindest eines Teils des Gesamtfluidstroms.

16. Statischer Mikrovermischer nach einem der Ansprüche 10 bis 15, **gekennzeichnet durch** eine Folge von einem oder mehreren weiteren Fokussierungskanälen (5', 5"), in die jeweils die vorhergehende Expansionskammer (6, 6', 6") übergeht, zum Ableiten und Fokussieren zumindest eines Teils des Gesamtfluidstroms und einen oder mehreren weiteren Expansionskammern (6', 6"), in die jeweils der vorhergehende weitere Fokussierungskanal (5', 5") einmündet, und
mindestens einem mit der in der Folge letzten Expansionskammer (6") fluidisch in Verbindung stehenden Auslasskanal (7) zum Ableiten der gebildeten Mischung.

17. Statischer Mikrovermischer nach einem der Ansprüche 10 bis 16, **dadurch gekennzeichnet, dass** in die Expansionskammer (6) ein oder mehrere Zuführkanäle (9a, 9b) zum Zuführen eines weiteren Fluids, beispielsweise ein einen die Mischung stabilisierenden Hilfsstoff aufweisendes Fluid, einmünden.

18. Statischer Mikrovermischer nach einem der Ansprüche 10 bis 17, **gekennzeichnet durch** einen oder mehrere weitere mit der Expansionskammer (6) in Verbindung stehende Auslasskanäle (10a, 10b) zum Ableiten der gebildeten Mischung.

19. Statischer Mikrovermischer nach einem der Ansprüche 10 bis 18, **gekennzeichnet durch** eine in der Expansionskammer (6) zum Ablenken des Fluidstrahls angeordnete Prallstruktur (11).

20. Statischer Mikrovermischer nach einem der Ansprüche 10 bis 19, **dadurch gekennzeichnet, dass** die Vielzahl benachbarter Fluidkanäle (2, 3; 12, 13), die Einlasskammer (4; 14), in die die Fluidkanäle (2, 3; 12, 13) einmünden, und der mit der Einlasskammer (4; 14) fluidisch in Verbindung stehende Fokussierungskanal (5; 15) jeweils zwei- oder mehrfach vorhanden sind und die zwei oder mehr Fokussierungskanäle (5; 15) in die eine gemeinsame Expansionskammer (16) einmünden.

21. Statischer Mikrovermischer nach einem der Ansprüche 10 bis 20, **dadurch gekennzeichnet, dass** die Strukturen der Fluidkanäle (2, 3), der Einlasskammer (4), des Fokussierungskanals (5) und der Expansionskammer (6) als Ausnehmungen und/ oder Durchbrüche in eine als Mischerplatte (20) dienende Platte aus einem für die zu mischenden Fluide ausreichend inerten Material eingebracht sind und diese offenen Strukturen durch eine mit der Mischerplatte fluidisch dicht verbundene Deck- und/ oder Bodenplatte (21, 22) abgeschlossen sind, wobei die Deck- und/ oder Bodenplatte (21, 22) Zuführungen (23, 24) für die beiden Fluide und/ oder mindestens eine Abführung (25) für die gebildete Mischung aufweisen.

22. Statischer Mikrovermischer nach Anspruch 21, **gekennzeichnet durch** eine zwischen der Mischerplatte (20) und der Bodenplatte (22) angeordnete und mit diesen fluidisch dicht verbundene Verteilerplatte (26) zum getrennten Zuführen der Fluide von den Zuführungen in der Bodenplatte (22) zu den Fluidkanälen (2, 3) in der Mischerplatte (20).

23. Statischer Mikrovermischer nach einem der Ansprüche 21 oder 22, **dadurch gekennzeichnet, dass** zumindestens die Mischerplatte (20) und die Deck- und/ oder Bodenplatte (23, 24) aus einem transparenten Werkstoff, insbesondere Glas oder Quarzglas, bestehen.

## Claims

1. Process for mixing at least two fluids having the steps:
- combining a number of separate fluid streams of the two fluids in each case of width in the range from 1 µm to 1 mm and a depth in the range from 10 µm to 10 mm with formation of alternating adjacent fluid lamellae of the two fluids,
- removing the combined fluid streams with formation of a focussed total fluid stream,
**characterised by** the steps
- introducing the focussed total fluid stream as a fluid jet into an expansion chamber (6) with a greater cross-sectional area with respect to the focussed total fluid stream vertically to the direction of flow of the focussed total fluid stream,
- withdrawing the mixture formed.

2. Process according to claim 1, **characterised in that** the combined fluid streams are focussed such that the ratio of cross-sectional area of the focussed total fluid stream to the sum of the cross-sectional areas of the fluid streams to be combined in each case vertically to the direction of flow lies in the range from 1:1.5 to 1:500, preferably in the range from 1:2 to 1:50.

3. Process according to one of claims 1 or 2, **characterised in that** the ratio of the length of the focussed total fluid steam to its width lies in the range from 1:1 to 30:1, preferably in the range from 1.5:1 to 10:1.

4. Process according to one of the previous claims, **characterised in that** the focussed total fluid stream is introduced as a fluid jet into the expansion chamber (6) such that stationary vortexes are formed at least in one plane on both sides of the fluid jet.

5. Process according to one of the previous claims, **characterised in that** at least some of the fluid stream is withdrawn again with focussing after introduction into the expansion chamber (6).

6. Process according to one of the previous claims, **characterised by** carrying out the following two process steps repeated once or several times
- removal of at least some of the fluid stream after previous introduction into the expansion chamber (6) with formation of a focussed fluid stream,
- introduction of the focussed fluid stream into a further expansion chamber (6', 6") with a greater cross-sectional area with respect to the focussed fluid stream vertically to the direction of flow of the focussed fluid stream,
wherein the mixture formed is withdrawn after the last step.

7. Process according to one of the previous claims, **characterised in that** a further fluid, for example a fluid having auxiliary material which stabilises the mixture, is introduced into the expansion chamber.

8. Process according to one of the previous claims, **characterised in that** at least some of the mixture formed is withdrawn from the region or regions of the expansion chamber with vortex formation.

9. Process according to one of the previous claims, **characterised in that** the first two process steps are carried out twice or several times in each case at the same time and separated spatially from one another and the two or more focussed total fluid streams thus obtained are introduced into the common expansion chamber.

10. Static micromixer (1) for mixing at least two fluids with a number of alternating adjacent fluid channels (2, 3) of width in the range from 1 µm to 1 mm and a depth in the range from 10 µm to 10 mm for separate supply of the fluids as fluid streams,
an inlet chamber (4), into which the fluid channels lead,
a focussing channel (5) in fluid connection with the inlet chamber (4) for removing the fluids streams combined in the inlet chamber (4) with formation of a focussed total fluid stream,
**characterised by**
an expansion chamber (6), into which the focussing channel (5) leads and the focussed total fluid stream may enter as a fluid jet having a greater cross-sectional area with respect to the focussing channel (4) vertically to the axis of the focussing channel (4) and
at least one outlet channel (7) in fluid connection with the expansion chamber (6) for withdrawing the mixture formed.

11. Static micromixer according to claim 10, **characterised in that** the inlet chamber (4) in its interior at least in one plane has a concave or semi-concave shape, with the concave surface (8), into which the focussing channel (5) leads centrally, opposite the surface, into which the fluid channels lead.

12. Static micromixer according to claim 10 or 11, **characterised in that** the ratio of the cross-sectional area of the focussing channel (5) to the sum of the cross-sectional areas of the fluid channels (2, 3) leading into the inlet chamber (4) in each case vertically to the channel axis lies in the range from 1:1.5 to 1:500, preferably in the range from 1:2 to 1:50.

13. Static micromixer according to one of claims 10 to 12, **characterised in that** the ratio of the length of the focussing channel (5) to its width lies in the range from 1:1 to 30:1, preferably in the range from 1.5: to 10:1.

14. Static micromixer according to one of claims 10 to 13, **characterised in that** the ratio of the cross-sectional area of the expansion chamber (6) in at least one central region to the cross-sectional area of the focussing channel (5) leading into the expansion chamber vertically to the channel axis lies in the range from 1.5:1 to 500:1, preferably in the range from 2:1 to 50:1.

15. Static micromixer according to one of claims 10 to 14, **characterised in that** the expansion chamber (6) changes into a further focussing channel (5') serving as an outlet channel (7) for withdrawal and renewed focussing at least of part of the total fluid stream.

16. Static micromixer according to one of claims 10 to 15, **characterised by** a sequence of one or more further focussing channels (5', 5"), into which in each case the previous expansion chamber (6, 6', 6") changes, for withdrawal and focussing at least of part of the total fluid stream and one or more further expansion chambers (6', 6"), into which in each case the previous further focussing channel (5', 5") leads, and at least one outlet channel (7) in fluid connection with the expansion chamber (6") which is last in the sequence, for withdrawal of the mixture formed.

17. Static micromixer according to one of claims 10 to 16, **characterised in that** one or more supply channels (9a, 9b) for supplying a further fluid, for example a fluid having an auxiliary material which stabilises the mixture, lead into the expansion chamber (6).

18. Static micromixer according to one of claims 10 to 17, **characterised by** one or more further outlet channels (10a, 10b) connected to the expansion chamber (6) for withdrawal of the mixture formed.

19. Static micromixer according to one of claims 10 to 18, **characterised by** an impact structure (11) arranged in the expansion chamber (6) for diverting the fluid jet.

20. Static micromixer according to one of claims 10 to 19, **characterised in that** the number of adjacent fluid channels (2, 3; 12, 13), the inlet chamber (4; 14), into which the fluid channels (2, 3; 12, 13) lead, and the focussing channel (5; 15) in fluid connection with the inlet chamber (4; 14) are present in each case twice or several times and the two or more focussing channels (5; 15) lead into the one common expansion chamber (16).

21. Static micromixer according to one of claims 10 to 20, **characterised in that** the structures of the fluid channels (2, 3), the inlet chamber (4), the focussing channel (5) and the expansion chamber (6) are introduced as recesses and/or perforations in a plate serving as a mixer plate (20) and made from a material which is adequately inert for the fluids to be mixed and these open structures are closed by a cover and/or base plate (21, 22) in tight fluid connection with the mixer plate, wherein the cover and/or base plate (21, 22) have supplies (23, 24) for the two fluids and/or at least one discharge (25) for the mixture formed.

22. Static micromixer according to claim 21, **characterised by** a distributor plate (26) arranged between the mixer plate (20) and the base plate (22) and in tight fluid connection with the latter, for separate supply of the fluids from the supplies in the base plate (22) to the fluid channels (2, 3) in the mixer plate (20).

23. Static micromixer according to one of claims 21 or 22, **characterised in that** at least the mixer plate (20) and the cover and/or base plate (23, 24) consist of a transparent material, in particular glass or quartz glass.

## Revendications

1. Procédé pour le mélange d'au moins deux fluides comprenant les étapes consistant à :
- Réunir plusieurs flux de fluide séparés de deux fluides d'une largeur s'inscrivant à chaque fois entre 1 µm et 1 mm et d'une profondeur s'inscrivant dans une plage de 10 µm à 1 mm en formant des lamelles de fluide alternativement voisines des deux fluides,
- Eliminer les flux de fluide réunis en formant un flux de fluides commun,
**caractérisé par** les étapes consistant à:
- Introduire le flux de fluides commun focalisé comme un faisceau fluide dans une chambre d'expansion (6) présentant une surface de section supérieure au flux de fluide commun focalisé perpendiculairement au sens d'écoulement du flux de fluide commun focalisé,
- A détourner le mélange formé.

2. Procédé selon la revendication 1, **caractérisé en ce que** les flux de fluide réunis sont focalisés de sorte à ce que le comportement de la surface de la section des flux de fluide commun focalisé corresponde à la somme de la surface de la section des flux de fluide à réunir, à chaque fois de manière perpendiculaire au sens d'écoulement, dans une plage de 1 : 1,5 à 1 : 500, de préférence, dans une plage de 1 : 2 jusqu'à 1 : 50.

3. Procédé selon l'une quelconque des revendications 1 à 2, **caractérisé en ce que** le rapport de la longueur du flux de fluide commun focalisé par rapport à sa largeur se trouve dans une plage de 1 : 1 à 30 : 1, de préférence, dans une plage de 1,5 : 1 à 10 : 1.

4. Procédé selon l'une quelconque des revendications précédentes, **caractérisé en ce que** le flux de fluide commun focalisé est introduit comme faisceau de fluide dans une chambre d'expansion (6), de telle sorte que des volutes stationnaires se forment au moins dans un niveau par rapport aux deux côtés du faisceau de fluide.

5. Procédé selon l'une quelconque des revendications précédentes, **caractérisé en ce qu'**au moins une partie du flux de fluide est détournée après l'introduction dans la chambre d'expansion (6), de nouveau sous focalisation.

6. Procédé selon l'une quelconque des revendications précédentes, **caractérisé par** une réalisation répétée plusieurs fois ou une seule fois des deux étapes du procédé suivantes consistant à :
- éliminer au moins une partie du flux de fluide après l'introduction préalable dans la chambre d'expansion (6) en formant un flux de fluide focalisé,
- introduire le flux de fluide focalisé dans une autre chambre d'expansion (6', 6") avec un flux de fluide présentant une surface de section supérieure dans la direction du flux de fluide focalisé perpendiculairement au sens d'écoulement du flux de fluide focalisé,
le mélange formé étant détourné au cours de l'étape suivante.

7. Procédé selon l'une quelconque des revendications précédentes, **caractérisé en ce qu'**un autre fluide est introduit dans la chambre d'expansion, par exemple, un fluide présentant un adjuvant stabilisant le mélange.

8. Procédé selon l'une quelconque des revendications précédentes, **caractérisé en ce qu'**au moins une partie du mélange formé est détournée à partir du domaine ou des domaines de la chambre d'expansion au moyen de la formation de volutes.

9. Procédé selon l'une quelconque des revendications précédentes, **caractérisé en ce que** les deux premières étapes du procédé sont exécutées à chaque fois simultanément et séparément l'une de l'autre dans l'espace à deux ou plusieurs reprises, et **en ce que** les deux ou plusieurs flux de fluide communs focalisés ainsi obtenus sont introduits dans la chambre d'expansion commune.

10. Micromélangeur statique (1) destiné au mélange d'au moins deux fluides présentant une multitude de canaux de fluide alternativement voisins (2, 3) d'une largeur s'inscrivant dans une plage de 1 µm à 1 mm, et d'une profondeur s'inscrivant dans une plage de 10 µm à 10 mm, pour l'alimentation séparée de fluides en tant que flux de fluide,
une chambre d'admission (4), dans laquelle débouchent les canaux de fluide,
un canal de focalisation (5) en contact par l'intermédiaire d'un fluide avec la chambre d'admission (4) pour l'élimination des flux de fluide unifiés dans la chambre d'admission (4) en formant un flux de fluide commun focalisé,
**caractérisé en ce que**
une chambre d'expansion (6), dans laquelle débouche le canal de focalisation (5) et dans laquelle le flux de fluide commun focalisé peut survenir comme faisceau fluide, présentant une surface de section supérieure au niveau du canal de focalisation (4), perpendiculairement à l'axe du canal de focalisation (4), et
au moins un canal d'évacuation (7) en contact avec la chambre d'expansion (6) au moyen d'un fluide pour détourner le mélange formé.

11. Micromélangeur statique selon la revendication 10, **caractérisé en ce que** la chambre d'admission (4) présente une forme concave ou demi-concave dans sa partie interne, au moins dans un niveau, laquelle forme comprend une surface concave (8) dans laquelle le canal de focalisation (5) débouche en son milieu face à la surface sur laquelle les canaux de fluide débouchent.

12. Micromélangeur statique selon la revendication 10 ou 11, **caractérisé en ce que** le rapport de la surface de section des canaux de focalisation (5) par rapport à la somme de la surface de la section des canaux de fluide (2, 3) débouchant dans la chambre d'admission (4), à chaque fois de façon perpendiculaire par rapport à l'axe du canal, se trouve dans une plage de 1 : 1,5 à 1 : 500, de préférence, dans une plage de 1 : 2 à 1 : 50.

13. Micromélangeur statique selon l'une quelconque des revendications 10 à 12, **caractérisé en ce que** le rapport de la longueur du canal de focalisation (5) par rapport à sa largeur s'inscrit dans une plage de 1 : 1 à 30 : 1, de préférence, dans une plage de 1,5 : 1 à 10 : 1.

14. Micromélangeur statique selon l'une quelconque des revendications 10 à 13, **caractérisé en ce que** le rapport de la surface de section de la chambre d'expansion (6) dans au moins un domaine intermédiaire par rapport à la surface de la section du canal de focalisation (5) débouchant dans la chambre d'expansion perpendiculairement à l'axe du canal s'inscrit dans une plage de 1,5 : 1 à 500 : 1, de préférence, dans une plage de 2 : 1 à 50 : 1.

15. Micromélangeur statique selon l'une quelconque des revendications 10 à 14, **caractérisé en ce que** la chambre d'expansion (6) fusionne dans un autre canal de focalisation (5') servant de canal de sortie (7) pour détourner et focaliser de nouveau au moins une partie du flux de fluide commun.

16. Micromélangeur statique selon l'une quelconque des revendications 10 à 15, **caractérisé par** une succession d'un ou de plusieurs autres canaux de focalisation (5', 5"), dans lesquels la chambre d'expansion précédente fusionne à chaque fois (6, 6', 6") pour détourner et focaliser au moins une partie du flux de fluide commun et, d'une ou plusieurs autres chambres d'expansion (6', 6") dans lesquelles l'autre canal de focalisation (5', 5") précédent débouche à chaque fois, et
au moins un canal de sortie (7) lié par un fluide à la suite de la dernière chambre d'expansion (6") pour détourner le mélange formé.

17. Micromélangeur statique selon l'une quelconque des revendications 10 à 16, **caractérisé en ce qu'**un ou plusieurs canaux d'alimentation (9a, 9b) débouche(nt) dans la chambre d'expansion (6) pour amener un autre fluide, par exemple, un fluide présentant un adjuvant stabilisant le mélange.

18. Micromélangeur statique selon l'une quelconque des revendications 10 à 17, **caractérisé par** un ou plusieurs autres canaux de sortie (10a, 10b) relié avec la chambre d'expansion (6) pour détourner le mélange formé.

19. Micromélangeur statique selon l'une quelconque des revendications 10 à 18, **caractérisé par** une structure à impact (11) agencée dans la chambre d'expansion (6) pour détourner le faisceau de fluide.

20. Micromélangeur statique selon l'une quelconque des revendications 10 à 19, **caractérisé en ce que** les nombreux canaux de fluide voisins (2, 3 ; 12, 13), la chambre d'admission (4 ; 14), dans laquelle les canaux de fluide (2, 3 ; 12, 13) débouchent, et le canal de focalisation (5 ; 15) relié, par l'intermédiaire d'un fluide, avec la chambre d'admission (4 ; 14) existe à chaque fois en deux ou plusieurs exemplaires et les deux ou plusieurs canaux de focalisation (5 ; 15) débouchent dans l'une des chambres d'expansion communes (16).

21. Micromélangeur statique selon l'une quelconque des revendications 10 à 20, **caractérisé en ce que** les structures des canaux de fluide (2, 3), de la chambre d'admission (4), du canal de focalisation (5) et de la chambre d'expansion (6) sont utilisés comme des entailles et/ou des ruptures dans une plaque servant de plaque de mélange (20) composée d'un matériau suffisamment inerte pour les fluides à mélanger et ces structures ouvertes sont obturées par une plaque de fond et/ou une plaque de recouvrement de façon étanche aux fluides avec une plaque de mélange, la plaque de recouvrement et la plaque de fond (21, 22) présentant des alimentations (23, 24) pour les deux fluides et/ou au moins une évacuation (25) pour le mélange formé.

22. Micromélangeur statique selon la revendication 21, **caractérisé par** une plaque de répartition liée de façon étanche aux fluides avec celui-ci et agencée entre la plaque de mélange (21) et la plaque de fond (22), pour amener de façon séparée les fluides depuis les alimentations se trouvant dans la plaque de fond (22) vers les canaux de fluide (2, 3) dans la plaque de mélange (20).

23. Micromélangeur statique selon l'une quelconque des revendications 21 ou 22, **caractérisé en ce qu'**au moins la plaque de mélange (20) et la plaque de recouvrement et/ou de fond (23, 24) se composent d'un matériau transparent, notamment de verre ou de verre de quartz.
